# EUROPEAN PATENT APPLICATION

(11) **EP 2 690 780 A2**
(43) Date of publication of application: **29.01.2014**
(21) Application number: 13176181.9
(22) Date of filing: 11.07.2013
(51) Int. Cl.: H03H 3/00, H03H 7/01, H03H 1/00

(54) **Electrical component**

(30) Priority: 26.07.2012 GB 201213347
(71) Applicant: Oxley Developments Company Limited, Ulverston Cumbria LA12 9QG (GB)
(72) Inventor: Johnson, Mark Christopher, Ulverston, Cumbria LA12 9QG (GB)
(74) Representative: WP Thompson

(57) **Abstract**

The invention concerns an electrical LC component (50) which may in particular be a filter. The component has a ceramic body (52) which is shaped to define a trough (82). At least one through-going opening (58, 60) in the ceramic body extends from the trough to an exterior surface of the ceramic body. An inductor (56) is housed in the trough and has a wire lead (84, 86) which extends into the through-going opening and is thereby connected to a contact (62, 64) on the exterior of the ceramic body. A capacitor is formed within the ceramic body by a set of capacitor plates (72, 74) which are electrically connected to the wire inductor lead and are interleaved with a further set of capacitor prates (76) which are electrically isolated from the wire inductor lead.

## Description

The present invention relates to LC electrical components and electrical filter components.

An LC circuit has at least one inductor and at least one capacitor. Such circuits have many purposes but may in particular be used as filters.

Electrical filters are well known to the skilled electrical or electronic engineer. Typically an LC circuit of some form serves to attenuate signal frequencies in a chosen range. Filters have a very wide range of applications. One example is removal of noise from an information carrying signal. For instance there is a common requirement for electrical connectors carrying data signals to incorporate filtering.

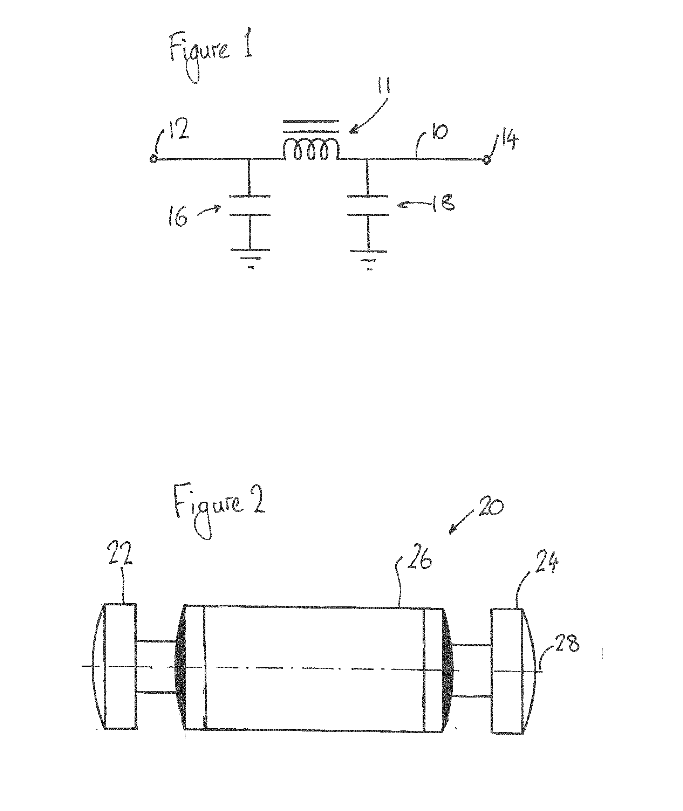

One well known filter circuit is the pi or capacitor-input filter and is represented in Figure 1. A signal line 10 leads from a first terminal 12 to a second terminal 14 via an inductor 11. A first capacitor 16 is connected between earth and the first terminal 12. A second capacitor 18 is connected between earth and the second terminal 14. That is, on either side of the inductor 11 there is a respective capacitor leading to earth.

In operation the inductor 11 offers impedance to AC signal components. The first and second capacitors 12 and 14 have low reactance to AC but very high resistance to DC components, and thus shunt AC signal components of sufficiently high frequency to earth without removing the DC component. The result is a low pass filter. That is, the filter has a low frequency pass band and attenuates higher frequencies.

Many other LC (inductor/capacitor) filter circuits exist.

While filters are often implemented using discrete components, it is known to manufacture them instead in a compact unitary package. Figure 2 shows the exterior of a known filter device 20 manufactured by Oxley Developments Co. Ltd. This is a surface mount device. That is, it is to be mounted directly upon a printed circuit board. End caps 22, 24 form first and second signal terminals. A body 26 between them has a metal exterior which forms a ground terminal. Internal structure is not shown in the drawing but within the metal outer layer of the body 26 is an inductor connected between the signal terminals. Two ceramic capacitors are provided on opposite sides of the inductor. These are discoidal components. Their capacitor plates are oriented normal to the axis 28 of the filter device 20. Each has a set of capacitor plates connectable through the body 26 to earth, interleaved with a set of capacitor plates connected to the respective end cap 22 or 24, forming a pi filter.

This construction can provide a very compact surface mount filter device and it has in fact been commercially successful. However there are important practical and commercial incentives to provide an improved filter package.

Customers require high performance. There is a need to maximise the capacitance that can be provided within a limited device volume, while at the same time maintaining a high withstand voltage. That is, dielectric layers separating the capacitor plates must be able to withstand high voltage without breaking down. The requirements are particular stringent in for example the avionics field, where filter packages of the type seen in Figure 2 are used at device inputs and outputs to remove signal noise. Aircraft being built today have design lifetimes spanning several decades. Dielectric properties - both permittivity and withstand voltage - degrade over time. Consequently it is a common practice to over-specify filter devices, in order that they will still meet design requirements when their performance has degraded over many years of use.

To maximise performance it is desirable to maximise the area of the capacitor plates. A device configuration is needed which makes this possible, while at the same time being straightforward to manufacture, and compact.

In accordance with the present invention, there is an electrical LC component comprising:
a ceramic body shaped to form a trough and to form at least one through-going opening extending from the trough to an exterior surface of the ceramic body;
a contact formed on the exterior of the ceramic body;
an inductor which is housed in the trough and which has a wire lead which extends into the through-going opening and is thereby connected to the contact;
   and
a capacitor formed within the ceramic body by a set of capacitor plates which are electrically connected to the wire inductor lead, interleaved with a further set of capacitor plates which are electrically isolated from the wire inductor lead.

In accordance with a second aspect of the present invention there is an electrical filter comprising:
a ceramic body shaped to form a trough and to form first and second through-going openings extending from the trough to an outer surface of the ceramic body,
an inductor which is housed in the trough and which has first and second wire inductor leads, the first wire inductor lead extending into the first through-going opening and being thereby electrically coupled to a first contact on the exterior of the ceramic body, the second wire inductor lead extending into the second through-going opening and being thereby electrically coupled to a second contact on the exterior of the ceramic body;
a shared contact which is accessible from the exterior of the ceramic body;
a first capacitor formed by a first stack of capacitor plates within the ceramic body, the first stack of capacitor plates being around or adjacent the first through-going opening and comprising capacitor plates which are electrically connected to the first wire inductor lead and are isolated from the shared contact, interleaved with capacitor plates which are electrically connected to the shared contact and are isolated from the first wire inductor lead;
a second capacitor formed by a second stack of capacitor plates within the ceramic body, the second stack of capacitor plates being around or adjacent the second through-going opening and comprising capacitor plates which are electrically connected to the second wire inductor lead and are isolated from the shared contact, interleaved with capacitor plates which are electrically connected to the shared contact and are isolated from the second wire inductor lead.

Specific embodiments of the present invention will now be described, by way of example only, with reference to the accompanying drawings, in which:-
Figure 1 is a circuit diagram of a pi filter belonging to the prior art;
Figure 2 is a side view of a filter component also belonging to the prior art;
Figure 3 is a perspective illustration of an electrical filter device embodying the present invention;
Figure 4 is an exploded view of the same filter device; and
Figures 5a, b and c are respectively top, side and bottom views of the same filter device.

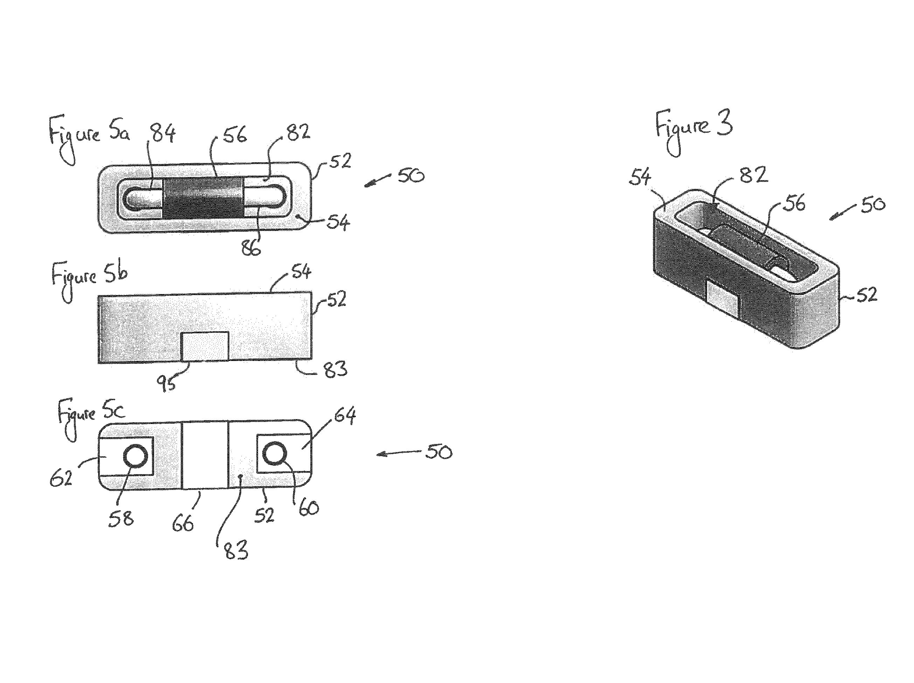

Briefly described, the filter device 50 of Figures 3 to 5 is a unitary component having a single monolithic ceramic body 52 within which are formed plates for the two capacitors of a pi filter. A trough 82 in a first face (arbitrarily referred to as the upper face 54 hereinbelow) receives the pi filter's inductor 56. Through-going openings 58, 60 in the ceramic body 52 provide for connections to the inductor's terminals and lead to respective contact pads 62, 64 on the exterior of the ceramic body 52. An earth contact 66 shared by the two capacitors is also formed on the exterior of the ceramic body 52 and the device is thus suitable for surface mounting on a circuit board.

The construction of the filter device 50 will now be described in greater detail.

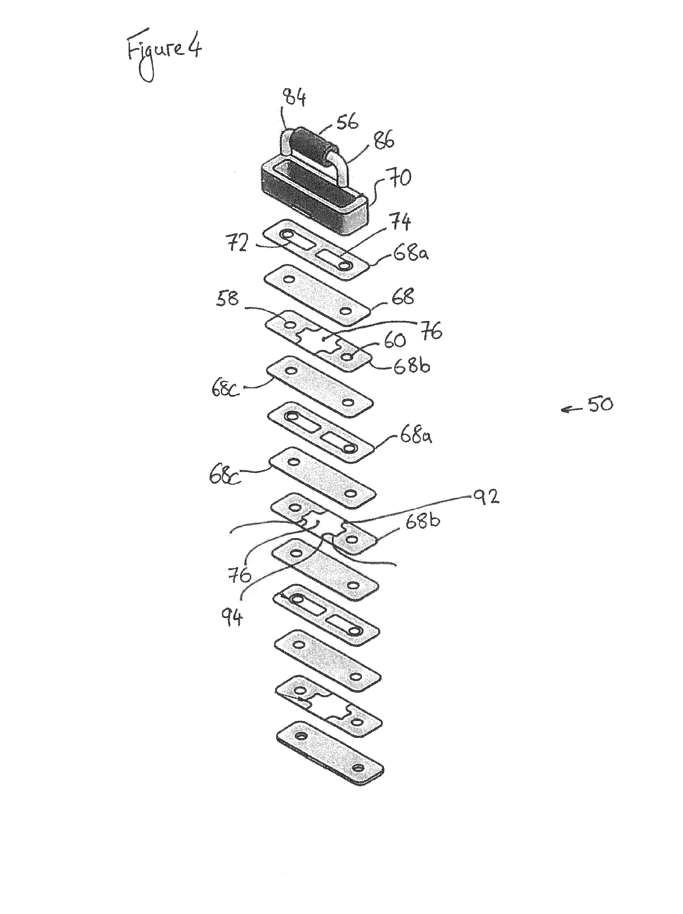

The internal structure of the ceramic body 50 can best be understood from the exploded view of Figure 4. It embodies "planar array" technology, being formed from multiple planar layers of dielectric (and more specifically ceramic). Some or all of the ceramic layers 68, 70 carry designs formed by a conductive (metal) layer which forms the capacitors. The drawing is simplified in that it shows only a small number of these layers but in a real device the thickness of each layer making up the planar capacitor array can be 0.05mm or even less and 50 or more individual layers can be provided. Note that these figures are given by way of example and not limitation. Both may vary considerably according to required filter specification.

In the illustrated example the ceramic layers are of three types. Signal plate layers 68a each carry first and second signal capacitor plates 72, 74, formed as rectangles in the illustrated embodiment although the shape of the plates can be changed according to design requirements. The signal plate layers 68a are interleaved with earth plate layers 68b which each carry an earth plate 76. That is, signal plate layers 68a and earth plate layers 68b alternate in the stack. Note that although the device has a pair of capacitors, the earth plates 76 are common to both. Again, there are any number of design alternatives but in the illustrated device the earth plate 76 has a roughly cruciform shape, two limbs 78, 80 of the cross overlapping the respective signal plates 72, 74 to provide the required capacitances.

In this particular embodiment each signal plate layer 68a is separated from its neighbouring earth plate layer 68b by a respective dielectric layer 68c, which in this example is blank - i.e. it carries no metal pattern. In this way the required depth of dielectric material between adjacent capacitor plates is provided. In other embodiments the dielectric layer 68c may be dispensed with, the plate layers 68a and 68b then providing the required dielectric depth and properties.

Atop the stacked layers making up the planar capacitor array is the deeper dielectric (specifically ceramic) housing layer 70 which houses the inductor 56. For this purpose the housing layer 70 is shaped to form the trough 82 which is initially open to the exterior to enable insertion of the inductor. During manufacture an encapsulant (in this example formed of epoxy resin) is used to fill the trough 82 around the inductor, giving the finished device a flat upper face 54.

The inductor 56 is in the present example a ferrite bead inductor. This type of component is known to the skilled person and will not be described herein. Other types of inductor may be used. The inductor has first and second wire terminals or legs 84, 86. As mentioned above, the ceramic body 52 has first and second through-going openings (bores) 58, 60 leading from lower face 83 of the ceramic body 52 (see Figure 5c) to the interior of the trough 82. The first and second inductor legs 84, 86 extend into the respective bores 58, 60 and connections from the legs to the corresponding signal capacitor plates are made by metallisation of the bores 58, 60.

Note that the first and second signal capacitor plates 72, 74 extend to and around the first and second openings 58, 60 respectively.

To form the required earth connection to the earth plates 76, two limbs 92, 94 of the earth plates' cruciform shape extend to edges of their ceramic layers 68b and are thus initially exposed at the exterior of the ceramic body 52. Metallising the exterior of the ceramic body in these regions 95 (see Figure 5b) connects the earth plates 76 to one another.

It will be apparent to the skilled reader that the filter device 50 provides first and second capacitors, each connected between earth and a respective, opposite, side of the inductor 56, and thus forms a pi filter.

Figures 5b and 5c show one possible contact arrangement. The first and second signal contact pads 62, 64 are formed on the device's lower face 83 and are electrically connected to the metallisation in the respective openings 58, 60. Between them is the earth contact 66 which is electrically connected to the metallised regions 95. This arrangement has been used in practice and allows for surface mounting. However in a commercial version it is intended that the signal and earth contact pads will extend around all four side faces of the ceramic body 52, enabling it to be placed upon a circuit board with any of these faces lowermost. This facilitates robotic "pick and place" manufacturing since the robotic system used to position the component need not orient any particular face downwards.

The process of manufacture of the filter device 50 will now be described. Note that the device structure described above lends itself to rapid and economical manufacture in large quantities. Many of the techniques involved are in themselves well known to the skilled reader and need only be briefly discussed herein.

The ceramic material forming the layers 68, 70 is in the illustrated example barium titanate and is cast in a continuous length, its thickness being regulated by a doctor blade. The resultant sheets are slit to form green ceramic tape, typically of the order of 8 centimetres in width, and the tape is cut into rectangular sheets which are bored to accommodate corner dowels for alignment.

The pattern forming the signal and capacitor plates 72, 74, 76 is formed by screen printing of metal onto the ceramic sheets. In the present example palladium silver is the chosen metal although other suitable materials may be used. At this point each ceramic sheet carries the capacitor plates for a large number of individual filter devices 50.

Following the screen printing process the ceramic sheets, still in their green state, are stacked, using the aforementioned corner dowels to align them with one another. The top layer of the stack is the relatively thick ceramic layer 70 which will accommodate the inductor 56 (note that this could itself be formed from multiple layers of ceramic).

Pressure is applied to the stacked ceramic sheets. In the present example this is done in a hydrostatic press. The stack of sheets is placed in a waterproof, sealed bag and then in a water tank, and by raising water pressure in the tank the ceramic sheets are forced into intimate contact with one another. This method ensures consistent application of pressure across the surfaces of the assembly. Other means of compression could however be used.

A computer controlled machining station, specifically a router, is used to machine into the ceramic the following features of the shape of the ceramic body 52:
(a) the trough 82;
(b) the through-going openings 88, 90; and
(c) the perimeter of the ceramic body 52 - its end and side faces 102, 104.

The ceramic is fired to form it into a unitary, monolithic block.

Following insertion of the inductor 56, the encapsulant is introduced into the trough 82 and its outer surface may be machined to flatten it. Metallisation is carried out to form the contact pads 62, 64 and to fill the openings 58, 60. This can be carried out by selectively coating the ceramic body 52 with a suitable resist, then applying a suitable plating process such as immersion plating.

This process has been described by way of example and not limitation. Numerous variation are possible. For instance the formation of the capacitors' signal and earth plates 72, 74, 76 could be done by selectively printing the ceramic sheets with resist and then applying a plating process.

Also the construction of the filter device 50 can be subject to numerous modifications without departing from the scope of the invention according to the appended claims. In particular, the circuit implemented by the device could be something other than a pi filter. It could, for example, be some other form of LC circuit, including a circuit having one or more capacitors and/or one or more inductors.

## Claims

1. An electrical LC component comprising:
a ceramic body shaped to form a trough and to form at least one through-going opening extending from the trough to an exterior surface of the ceramic body;
a contact formed on the exterior of the ceramic body;
an inductor which is housed in the trough and which has a wire lead which extends into the through-going opening and is thereby connected to the contact; and
a capacitor formed within the ceramic body by a set of capacitor plates which are electrically connected to the wire inductor lead, interleaved with a further set of capacitor plates which are electrically isolated from the wire inductor lead.

2. An electrical LC component as claimed in claim 1 in which the capacitor plates lie in mutually parallel planes at least substantially perpendicular to the through-going opening.

3. An electrical LC component as claimed in claim 1 or claim 2 in which the trough is formed in a first face of the ceramic body and the through-going opening leads to a second face of the ceramic body, the first and second faces being on opposite sides of the ceramic body.

4. An electrical LC component as claimed in any preceding claim in which the capacitor plates which contact the wire inductor lead border the through-going opening and are connected to the wire inductor lead through metallisation of the interior of the through-going opening.

5. An electrical LC component as claimed in any preceding claim in which the ceramic body is shaped to provide two through-going openings and the inductor has two wire leads which extend into respective through-going openings.

6. An electrical LC component as claimed in claim 5 which has two capacitors formed within the ceramic body, each capacitor having a set of capacitor plates electrically connected to a respective inductor wire lead and a set of capacitor plates electrically connected to a shared contact on the exterior of the ceramic body.

7. An electrical LC component as claimed in claim 6 in which the capacitor plates connected to the shared contact extend to an outer face of the ceramic body and are connected to the shared contact by metallisation of that outer face.

8. An electrical LC component as claimed in any preceding claim which is a pi filter.

9. An electrical filter comprising:
a ceramic body shaped to form a trough and to form first and second through-going openings extending from the trough to an outer surface of the ceramic body,
an inductor which is housed in the trough and which has first and second wire inductor leads, the first wire inductor lead extending into the first through-going opening and being thereby electrically coupled to a first contact on the exterior of the ceramic body, the second wire inductor lead extending into the second through-going opening and being thereby electrically coupled to a second contact on the exterior of the ceramic body;
a shared contact which is accessible from the exterior of the ceramic body;
a first capacitor formed by a first stack of capacitor plates within the ceramic body, the first stack of capacitor plates being around or adjacent the first through-going opening and comprising capacitor plates which are electrically connected to the first wire inductor lead and are isolated from the shared contact, interleaved with capacitor plates which are electrically connected to the shared contact and are isolated from the first wire inductor lead;
a second capacitor formed by a second stack of capacitor plates within the ceramic body, the second stack of capacitor plates being around or adjacent the second through-going opening and comprising capacitor plates which are electrically connected to the second wire inductor lead and are isolated from the shared contact, interleaved with capacitor plates which are electrically connected to the shared contact and are isolated from the second wire inductor lead.

10. An electrical filter as claimed in claim 9 in which the capacitor plates lie in mutually parallel planes at least substantially perpendicular to the first and second through-going openings.

11. An electrical filter as claimed in claim 9 or claim 10 in which the shared contact is between the first and second contacts.

12. An electrical filter as claimed in any of claims 9 to 11 in which the trough is formed in a first face of the ceramic body and the through-going openings lead to a second face of the ceramic body, the first and second faces being on opposite sides of the ceramic body.

13. An electrical filter as claimed in any of claims 9 to 12 in which the first and second through-going openings are internally metallised and are thereby connected to the corresponding capacitor plates.

14. An electrical filter as claimed in any of claims 9 to 13 in which the capacitor plates which are electrically connected to the shared contact extend to an outer face of the ceramic body, the outer face being metallised to form the shared contact.

15. A method of manufacture of an electrical LC component as claimed in any of claims 1 to 8, comprising:
providing multiple sheets of unfired ceramic;
forming a contact pattern for multiple LC components on at least some of the sheets of unfired ceramic;
stacking the sheets of unfired ceramic;
compressing the resultant stack;
machining the stack to form the aforementioned trough and through-going opening, and to divide the stack to form multiple LC components; and
firing the components.
